# EUROPEAN PATENT APPLICATION

(11) **EP 4 768 624 A1**
(43) Date of publication of application: **01.07.2026**
(21) Application number: 25183093.1
(22) Date of filing: 16.06.2025
(51) Int. Cl.: C23C 16/30, C23C 16/509

(54) **A METHOD OF CONTROLLING STRESS VARIATION IN A LAYER COMPRISING SILICON OXYCARBIDE FORMED USING PLASMA ENHANCED CHEMICAL VAPOUR DEPOSITION**

(30) Priority: 31.12.2024 GB 202419157
(71) Applicant: SPTS Technologies Limited, Newport NP18 2TA (GB)
(72) Inventor: Crook, Kathrine, Newport, NP18 2TA (GB); Toomer, Sam, Newport, NP18 2TA (GB); Cranton, Chenice, Newport, NP18 2TA (GB); Edmonds, Matthew, Newport, NP18 2TA (GB)
(74) Representative: Wynne-Jones IP Limited

(57) **Abstract**

A method of controlling stress variation in a layer comprising silicon oxycarbide formed using a capacitively coupled plasma enhanced chemical vapour deposition system, is disclosed. The method comprises the steps of:
- providing a chamber comprising a platen for supporting a substrate;
- placing a substrate, upon which a layer comprising silicon oxycarbide is formable, upon the platen;
- introducing a gas comprising oxygen into the chamber;
- introducing trimethylsilane gas into the chamber;
- generating a plasma within the chamber;
- maintaining a temperature at which deposition takes place to less than 275°C;
- maintaining a pressure within the chamber in the range 1.5-3Torr;
- depositing the layer upon the substrate with a deposition rate >1.5µm/minute.

## Description

The present invention relates to a method of controlling stress variation in a layer comprising silicon oxycarbide formed using plasma enhanced chemical vapour deposition.

### Background

Dielectric thin layers are widely used in the fabrication of semiconductor devices, MEMS devices and optical and electro-optical devices. During a deposition process, such as for example chemical vapour deposition (CVD), plasma enhance chemical vapour deposition (PECVD) and atomic layer deposition (ALD), stress will be incorporated into the dielectric thin layer. This stress can be due to extrinsic factors such as differences between the thermal expansion coefficient of the dielectric thin layer and an underlying substrate or intrinsic factors such as defects in the microstructure of the dielectric thin layer. The compressive or tensile stresses that can be present in the dielectric thin layers can result in undesirable wafer distortion, which in turn can prove problematic for subsequent process steps or can result in failure in the dielectric thin layer itself in the form of cracks or delamination.

Controlling stress becomes increasingly challenging when the coating thickness is increased. In applications where thick layers of SiO₂ having a thickness of greater than 10µm are required, conventional PECVD processes tend to be the preferred technique for high deposition rate processes. These conventional processes tend to require low deposition rates or multiple stress balancing layers to achieve a crack free layer with minimal wafer distortion. This results in a complicated deposition process with a low total deposition rate. For example, US9472610B2 discloses that it is not possible to deposit SiO₂ layers having a thickness of 20µm or greater at temperatures of 280°C or lower without cracking due to the build-up of stress in the layer and therefore uses of alternating tensile stressed and compressive stressed laminated layers to form a deposit of SiO₂. US2012/015113 A1 discloses forming multiple layers of thermal sub-atmospheric chemical vapour deposition (SACVD) and PECVD SiO₂ with a total layer thickness of up to 3.5µm.

The thermal budget that a wafer can accept is another constraint when considering the deposition process as deposition rate, layer density, and stress all are influenced by the deposition temperature. In many MEMS and 3D-packaging applications, there are demanding low-temperature constraints which limit the deposition temperatures to less than about 300°C in order to prevent damage or warping of the device.

In many schemes, a post dielectric deposition bow restriction of the wafer of less than 300µm is required over the wafer diameter. To achieve this bow restriction, a low stress variation is required across the wafer diameter and this is typically facilitated using a low rate of dielectric deposition. However, to make the deposition process cost efficient, high deposition rates of >1.5µm/minute are required. High deposition rates can lead to further challenges as high deposition rates typically increase the stress within the dielectric layers.

The currently preferred dielectric materials for filling the gaps between dies on a wafer include oxides of is tetraethyl orthosilicate (TEOS). TEOS based silicon dioxide for example is frequently used for this type of application due to the ease of stress tuning this material at low temperatures (<250°C). The stress of the TEOS oxide must be very tightly controlled to achieve a balance between wafer cracking threshold and bowing.

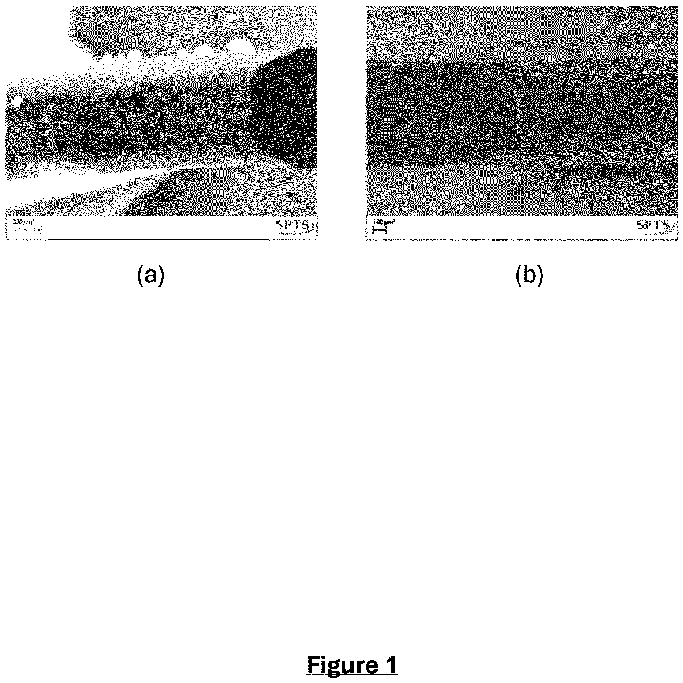

Upon referring to figure 1a and 1b of the drawings, there are illustrated scanning electron microscope (SEM) images of PECVD deposited films, deposited at 250°C, with a nominal thickness of 40µm. The plasma facing surface is the upper surface of the wafer in both cases. In figure 1a, a delamination is evident on the bevel, in this case for a TEOS based SiO₂ film. Figure 1b demonstrates the ideal deposition, when using a novel silicon oxycarbide film where there is a continuous film which gradually reduces in thickness near the bevel and does not delaminate.

It is believed that at the vertical edge of the bevel in figure 1a, the TEOS film is more tensile than the bulk of the film due to a reduced ion bombardment during the deposition process, and as a consequence results in a delamination of the thin film. The bevel area is also a source of cracks that ultimately can propagate into the bulk of the TEOS oxide film, i.e. beyond a 2mm edge exclusion area. Both delamination and cracking are unacceptable and therefore limit the use of these TEOS oxide films to smaller film thicknesses.

The introduction of carbon into the SiO matrix would be expected to reduce the density and potentially the stress within the film. However, if excessive carbon is introduced into the film the coefficient of thermal expansion would be expected to increase. Organic films have a high coefficient of thermal expansion, tend to be tensile in stress and are not practical in this type of application. The challenge is to introduce sufficient carbon into the SiO matrix while reducing film stress and producing a weakly compressive film with adequate mechanical strength. Accordingly, we have devised an improved method which exploits the use of a PECVD film comprising silicon oxycarbide, which address the above concerns and which seeks to extend the cracking threshold of these films to films having thickness >>40µm.

### Statements of Invention

In accordance with the present invention, there is provided a method of controlling stress variation in a layer comprising silicon oxycarbide formed using a capacitively coupled parallel plate plasma enhanced chemical vapour deposition system, the method comprising the steps of:
- providing a chamber comprising a platen for supporting a substrate;
- placing a substrate, upon which a layer comprising silicon oxycarbide is formable, upon the platen;
- introducing a gas comprising oxygen into the chamber;
- introducing trimethylsilane gas into the chamber;
- generating a plasma within the chamber;
- maintaining a temperature at which deposition takes place to less than 275°C;
- maintaining a pressure within the chamber in the range 1.5-3Torr;
- depositing the layer upon the substrate with a deposition rate >1.5µm/minute.

TEOS SiO₂ produces edge defects when thick films are deposited. Edge defects are undesirable as if they can be cleaned, they need an additional process step. The introduction of C into the SiO matrix results in lower stress film which can achieve very thick films with no edge defects. Deposition rates and film uniformity values are found to be similar or better than TEOS based films.

The oxygen containing gas can comprise oxygen gas or nitrous oxide. In a first embodiment in which the oxygen containing gas comprises oxygen gas, the oxygen gas is introduced into the chamber with a flow rate in the range 300-360sccm, optionally 333sccm. In a second embodiment in which the oxygen containing gas comprises nitrous oxide, the nitrous oxide is introduced into the chamber with a flow rate in the range 1160-1560sccm, optionally 1360sccm. In the second embodiment, the method can further comprise introducing argon gas into the chamber, and this can be performed with a flow rate of the argon gas in the range 254-414sccm, optionally 384sccm.

The method further comprises introducing trimethylsilane gas into the chamber with a flow rate in the range 330-380sccm. Optionally, in the first embodiment, trimethylsilane gas is introduced into the chamber with a flow rate of 380sccm, whereas in the second embodiment, trimethylsilane gas is introduced into the chamber with a flow rate of 330sccm.

The method further comprises maintaining the temperature at which deposition takes place in the range 225-275°C. Optionally, the temperature is maintained at 250°C in connection with both embodiments.

The plasma can be generated by one or more radio frequency (RF) power supplies which provide a mixed frequency power, comprising a high frequency component and a low frequency component. The high frequency component can comprise a power in the range 1100-1410W and the low frequency component can comprise a power in the range 0-600W. Optionally, in the first embodiment, the high frequency component comprises a power of 1210W and the low frequency component comprises a power of 400W. Optionally, in the second embodiment, the high frequency component comprises a power of 1200W and the low frequency component comprises a power of 0W.

In the first embodiment, the layer formed on the substrate comprises silicon oxycarbide. In the second embodiment, the layer formed on the substrate comprises nitrogen doped silicon oxycarbide.

In the first embodiment, the pressure is maintained in the chamber at substantially 2.5Torr and in the second embodiment, the pressure is maintained in the chamber at substantially 1.73Torr.

The dielectric constant for the silicon oxycarbide film comprises substantially 3.4. Similarly, the dielectric constant for the nitrogen doped silicon oxycarbide film comprises substantially 3.2.

### Brief Description of the Drawings

Figure 1a is a SEM image of a TEOS oxide based film showing delamination around a beveled film region;
Figure 1b is a SEM image of a silicon oxycarbide based film showing no delamination around a beveled film region;
Figure 2 is a schematic illustration of a system for performing PECVD of the film comprising silicon oxycarbide;
Figure 3 is a flowchart illustrating the steps associated with a method according to the present invention; and,
Figure 4 is a FTIR graph illustrating the absorbance spectrum of a silicon oxycarbide film (solid line) and a nitrogen doped silicon oxycarbide film (dotted line) deposited on silicon wafers, illustrating the signature bonds responsible for the absorption at various wavenumbers.

### Detailed Description of Embodiments of the Invention

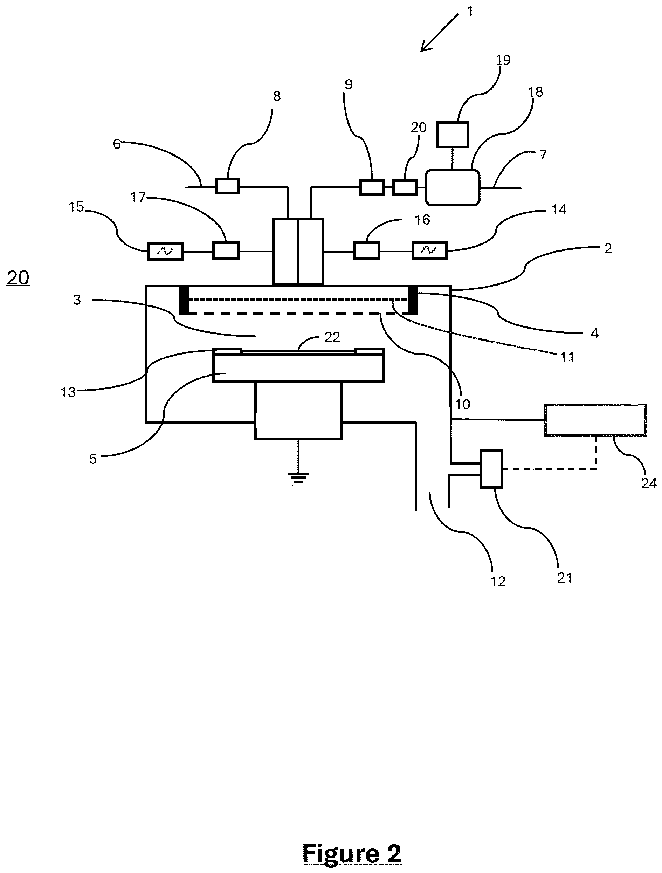

Referring to figure 2 of the drawings there is illustrated a schematic representation of a system 1 for controlling stress variation in a layer (not shown) formed upon a substrate via PECVD, according to method according to an embodiment of the present invention. The system 1 may comprise the SPTS Delta^{™} fxPECVD system and comprises an electrically grounded processing chamber 2 within which the PECVD process takes place. The chamber 2 comprises a process region 3 in which a plasma is created, which is defined between a substrate support or platen 5 and a gas inlet system comprising an aluminium showerhead 4. During use, gases pass into a rear side of the showerhead 4 and are projected into the process region 3 through a series of small holes 10 in the showerhead 4 via an internal gas distribution plate 11. The substrate support 5 is grounded and the showerhead 4 is powered by a plasma generating means comprising two different RF power supplies 14, 15, each of which operate at different RF frequencies, namely a high and low frequency, and their associated matching units 16, 17. The grounded substrate support 5 is resistively heated during use to heat the wafer and a cooling mechanism (not shown) enables control of the wafer temperature during the deposition process, in order to maintain a wafer temperature below 275°C.

There is a dielectric break (not shown) between the aluminium showerhead 4 and the metallic chamber 2. In a different embodiment, alternative plasma generating means may be used, for example with an arrangement wherein the substrate support 5 is RF driven and the gas distribution plate 11 is grounded. During use, process gases enter the gas inlet system through pipes 6, 7 comprising isolation valves 8, 9. Multiple gas sources are linked to pipes 6, 7 by means of a manifold (not shown) with isolation valves, mass flow controllers and related components. The grounded chamber 2 is evacuated though an exhaust 12 by means of a pump (not shown).

A typical process cycle commences by loading a substrate 22, such as a silicon wafer having a diameter of 200mm or 300mm, into the evacuated chamber 2 and placing the substrate onto the substrate support or platen 5. The substrate is placed within an annular uniformity ring 13 situated on the substrate support upper surface. A process gas or gas mixture passes through gas pipe 6 with the corresponding valve 8 open and enters the chamber 2 through the showerhead 4. When the desired gas flow and pressure are achieved a system controller 24 associated with the chamber 2 signals for RF power to be delivered by either or both of the RF supplies 14, 15 to the showerhead 4, thereby initiating a plasma within the chamber 2 between the showerhead 4 and the substrate support 5. Pressure is controlled by controlling the flow of gases into and out of the chamber 2, for example by controlling the pump speed through the exhaust and/or using mass flow controllers to control flow into the chamber, as will be understood in the art, in order to maintain the pressure within the chamber 2 to the range 1.5-3Torr.

The high frequency RF supply 14 operates at 10-20MHz while the low frequency RF supply 15 operates at 375kHz - 2MHz. Matching units 16 and 17 enable efficient coupling of the RF power into the showerhead 4.

When the desired thickness of deposition has been achieved, the controller 24 emits an OFF signal and the power is switched off and the process gas flow is stopped. The controller 24 is coupled to a plurality of sensors (not shown) within the chamber 2. The chamber 2 is evacuated as the process gases pass through the exhaust 12, and then the substrate 22 is removed from the chamber 2.

A high frequency RF power (in the example embodiment at 13.56 MHz) is applied across parallel plates within the reactor chamber to generate the plasma from the process gases. A first plate (i.e. electrode) is provided by the wafer support 5, which is grounded. A second plate (i.e. electrode) is provided by the showerhead 4, which is powered. Although the system 1 is capable of supplying mixed frequencies, in the example embodiment, the system can be utilised at a single frequency only. A relatively low RF power is supplied by a high frequency RF power supply 15 (in the example embodiment at 13.56MHz).

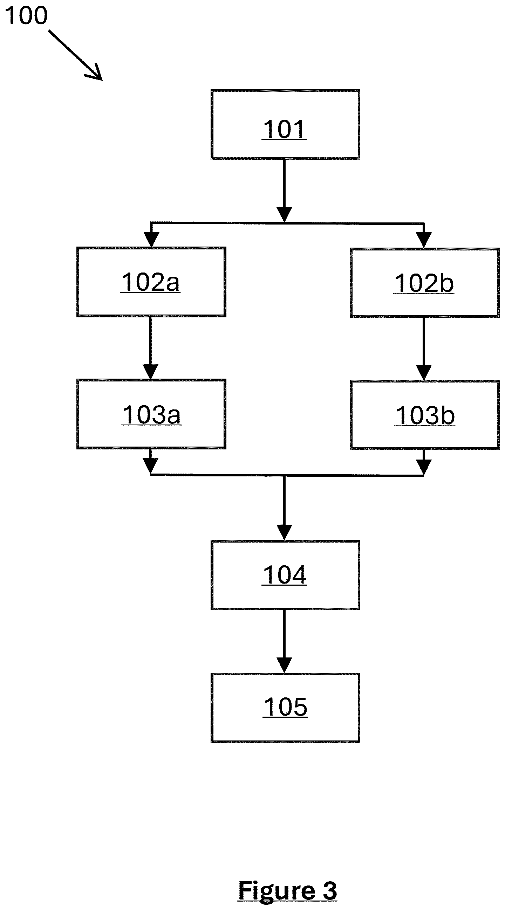

Referring to figure 3 of the drawings, there is provided a flowchart illustrating the steps associated with a method 100 according to an embodiment of the present invention, of controlling stress variation in a layer comprising silicon oxycarbide formed using PECVD. The method comprises the use of the system 1 disclosed above and comprises the initial step 101 of placing a substrate, namely a wafer 22, upon which the silicon oxycarbide layer is formable, upon the platen 5. In a first embodiment, oxygen gas is introduced into the chamber 2 along with trimethylsilane gas, via gas pipe 6 and the showerhead 4, at step 102a. The RF power supplies 14,15 are then activated at step 103a to generate a plasma within the chamber 2 between the showerhead 4 and the platen 5 in order to commence the PECVD process. In a second embodiment, the oxygen gas is replaced with nitrous oxide and argon gas is also introduced into the chamber 11 along with trimethysilane gas, via gas pipe 6 and the showerhead 4, at step 102b. The RF power supplies 14,15 are then similarly activated at step 103b to generate a plasma within the chamber 11 between the showerhead 4 and platen 5 in order to commence the PECVD process.

In the first embodiment, a silicon oxycarbide film is deposited on the wafer 22, whereas in the second embodiment, a nitrogen doped silicon oxycarbide film is deposited on the wafer 22. In both embodiments, the films were deposited at a rate of >1.5µm/minute and resulted in film thicknesses in the range 10-90µm. When the desired thickness of deposition has been achieved, the process gas flow into the chamber 2 is stopped and gases within the chamber are evacuated via exhaust 12, at step 104. The substrate 22 is then removed from the chamber 2 at step 105.

The process conditions associated with the first and second embodiments are illustrated in table 1 below:

**Table 1**

| Parameter | Unit | Range | Preferred Value | |
|---|---|---|---|---|
| | | | SiCO | SiCON |
| Deposition Temperature | °C | 225-275 | 250 | 250 |
| Pressure in chamber | mT | 1500 - 3500 | 2500 | 1730 |
| High frequency power component | W | 1100 - 1410 | 1210 | 1200 |
| Low frequency power component | W | 0-600 | 400 | 0 |
| Flow rate - Trimethylsilane | sccm | 330 - 380 | 380 | 330 |
| Flow rate - Ar | sccm | 354-414 | - | 384 |
| Flow rate - Oxygen | sccm | 300-360 | 333 | - |
| Flow rate - N₂O | sccm | 1160-1560 | - | 1360 |

A summary of the properties of the wafers with the deposited films according to the first and second embodiments is provided in table 2 below, together with a TEOS oxide film for comparison:

**Table 2**

| Parameter | SiCO | SiCON | TEOS Oxide |
|---|---|---|---|
| Wafer Size | 200mm | 200mm | 300mm |
| Non-uniformity (1σ) | 5.67 | 0.74 | 1.48 |
| RI | 1.4701 | 1.4686 | 1.4677 |
| Stress (MPa) | -13 | -9 | -16 |
| Hardness (GPa) | 3.0319 | 2.1050 | 6.9138 |
| Modulus (GPa) | 30.081 | 46.403 | 61.286 |

From table 2, it is evident that an acceptable uniformity is achieved in all cases, with the SiCON film providing the lowest non-uniformity value. It is anticipated that further refinement of the uniformity values could be achieved without adversely affecting other film properties.

It is also notable that the refractive index of the films gradually increases from the TEOS film to SiCON and the SiCO film. Most significantly for the deposition of thick films we can see a reduction in film stress from TEOS to SiCO, with the lowest compressive stress being with the SiCON film. These stress measurements were made on 1µm films. Stress values for crack free 40µm SiCO and SiCON films were -24MPa and -1MPa respectively. Modulus and hardness of the films are reduced for the SiCO and SiCON films when compared with the TEOS film. In addition, it is evident that both film variants showed excellent wafer bevel defectivity upon thick film deposition (40µm). Improved wafer bevel defectivity is desired in order to situate devices nearer to the edge of the wafer.

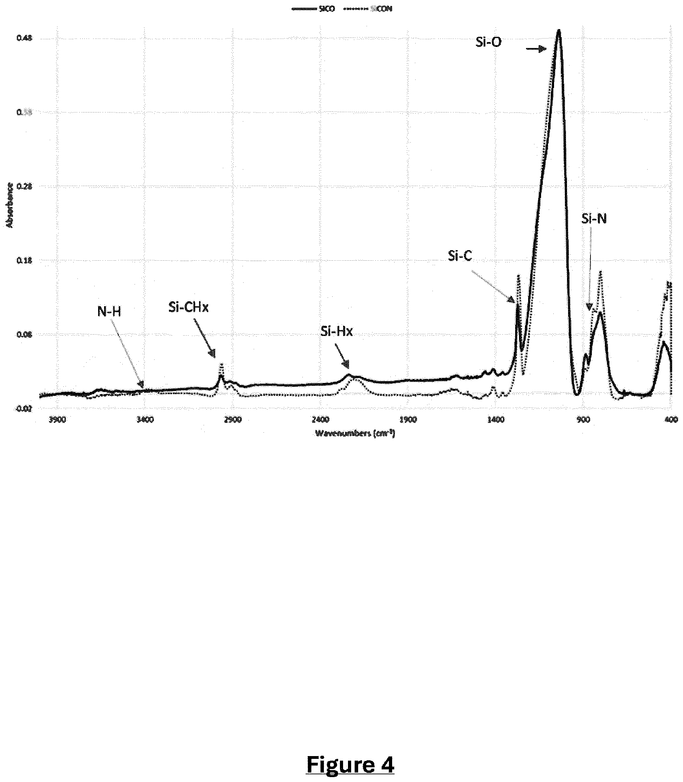

An FTIR analysis of both films was also performed using a Nicolet iS50 FT-IR spectrometer, and figure 4 provides a graph showing the absorbance spectrum of both the SiCO and SiCON film. The SiCO FTIR spectrum is the solid line whereas the SiCON FTIR spectrum is identified by the dotted line. Unlike the TEOS films which are dominated by the Si-O peak at ~1025cm⁻¹, the SiCO films also have Si-CHx peaks between 2965-2910cm⁻¹, SiC at 1271cm⁻¹ and Si-Hx peaks ~2280-2170cm⁻¹. While the SiCON films also show evidence of N incorporation with a weak N-H peak at 3390cm⁻¹ and a SiN peak at 840cm⁻¹.

The Si-CHx and SiC peaks are more pronounced in the SiCON case than for the SiC films suggesting the carbon content of these films is higher than the equivalent SiCO films. The films are hydrogenated silicon oxycarbides with the trimethylsilane/N₂O films containing N.

Surprisingly, the dielectric constant k value for the optimized SiCO film was 3.4, in contrast with a k value of 5.8 achieved by Laboda et. al (US6593655), suggesting increased incorporation of carbon into the film. The dielectric constant k value of the SiCON film was 3.2, suggesting a slightly higher carbon content to the SiCO films as indicated by the FTIR Si-CHx and SiC peaks.

The SiCO films of thickness up to 40µm and SiCON films of up to 90µm did not crack nor suffer any delamination around the bevel.

From the above, it is evident that the method disclosed herein provides an improved approach to the PECVD deposition of films comprising silicon oxycarbide.

## Claims

1. A method of controlling stress variation in a layer comprising silicon oxycarbide formed using a capacitively coupled plasma enhanced chemical vapour deposition system, the method comprising the steps of:
- providing a chamber comprising a platen for supporting a substrate;
- placing a substrate, upon which a layer comprising silicon oxycarbide is formable, upon the platen;
- introducing a gas comprising oxygen into the chamber;
- introducing trimethylsilane gas into the chamber;
- generating a plasma within the chamber;
- maintaining a temperature at which deposition takes place to less than 275°C;
- maintaining a pressure within the chamber in the range 1.5-3.5Torr;
- depositing the layer upon the substrate with a deposition rate >1.5µm/minute.

2. A method according to claim 1, wherein the oxygen containing gas comprises oxygen gas.

3. A method according to claim 2, wherein the oxygen gas is introduced into the chamber with a flow rate in the range 300-360sccm.

4. A method according to claim 1, wherein the oxygen containing gas comprises nitrous oxide.

5. A method according to claim 4, wherein the nitrous oxide gas is introduced into the chamber with a flow rate in the range 1160-1560sccm.

6. A method according to claim 4 or 5, further comprising introducing argon gas into the chamber, optionally wherein the argon gas is introduced into the chamber with a flow rate in the range 354-414sccm.

7. A method according to any preceding claim, wherein the trimethylsilane gas is introduced into the chamber with a flow rate in the range 330-380sccm.

8. A method according to any preceding claim, wherein the deposited layer comprises a thickness in the range 10-90µm.

9. A method according to any preceding claim, wherein the temperature within the chamber is maintained in the range 225-275°C.

10. A method according to any preceding claim, wherein the temperature within the chamber is maintained at substantially 250°C.

11. A method according to any preceding claim, wherein the plasma is generated using one or more RF power supplies with a mixed frequency power, comprising a high frequency component and a low frequency

12. A method according to claim 11, wherein the high frequency component comprises power in the range 1100-1410W.

13. A method according to claim 11 or 12, wherein the low frequency component comprises power in the range 0-600W.

14. A method according to any preceding claim, wherein the layer comprises silicon oxycarbide, optionally wherein the dielectric constant for the silicon oxycarbide film comprises substantially 3.4.

15. A method according to any of claims 1-13, wherein the layer comprises nitrogen doped silicon oxycarbide, optionally wherein the dielectric constant for the nitrogen doped silicon oxycarbide film comprises substantially 3.2.
